# EUROPEAN PATENT SPECIFICATION

(11) **EP 1 600 429 B1**
(45) Date of publication and mention of the grant of the patent: **16.05.2007**
(21) Application number: 05011221.8
(22) Date of filing: 24.05.2005
(51) Int. Cl.: C03C 17/42, C03C 17/34

(54) **Waterdrop slidable surface structure**
Wassertropfenverschiebare Oberflächenstruktur
Structure de surface permettant à l'eau de glisser

(30) Priority: 25.05.2004 JP 2004154233
(43) Date of publication of application: 30.11.2005
(73) Proprietor: HONDA MOTOR CO., Ltd., Tokyo (JP)
(72) Inventor: Hayakawa, Yukio, Wako-shi Saitama (JP)
(74) Representative: Rupp, Christian

(56) References cited:
- EP-A- 0 748 775
- EP-A- 0 866 037
- WO-A-02/06174
- KR-A- 2002 038 968
- US-A- 5 413 865
- US-A1- 2001 051 273
- US-A1- 2002 142 150
- PATENT ABSTRACTS OF JAPAN vol. 2000, no. 23, 10 February 2001 (2001-02-10) -& JP 2001 152138 A (SENTAN KAGAKU GIJUTSU INCUBATION CENTER:KK), 5 June 2001 (2001-06-05)

## Description

### BACKGROUND OF THE INVENTION

The present invention relates to a waterdrop slidable surface which sustains a waterdrop slidable property over extended period of time, and more particularly to a waterdrop slidable surface structure which achieves high durability for wiping actions of wiping means such as wipers of a vehicle.

In order to keep better visibility during driving in rain, water repellency is imparted, for example, on a surface of a vehicular windshield so that waterdrops sticking to the surface of the windshield are dispersed and slide thereon with own , weight of the waterdrops, thereby improving waterdrop slidable property. Conventionally, fluororesin is coated on a glass surface to improve waterdrop slidable property. Coating such fluororesin can provide improved water repellency of the glass surface, and waterdrops, oildrops and dirt hardly stick , to the glass surface

However, fluororesin is poor in adhesiveness with the glass surface as well as poor in abrasion resistance for wiping actions of wipers. Further, fluororesin is inferior in durability. In order to overcome such drawbacks, for example, Japanese Laid-open Patent Application No. Hei.06-56476 (paragraphs 0012 to 0015) discloses a technique wherein a mixture of such fluororesin and ceramic constituent that has better compatibility with glass and excels in abrasion resistance is coated on the glass surface.

However, the above technique has a drawback in that although the durability of the coating film increases with increasing the content of ceramic constituent, the water repellency decreases to such an extent that the exposing area of the fluororesin on the glass surface decreases. Meanwhile, although the water repellency increases with decreasing the content of such ceramic constituent, the durability of the coating film decreases.

Patent document US 5,413,865 relates to a water-repellent metal oxide film suitable for applications, for example, to vehicular and architectural window glasses which are to be exposed to rain water. The document discloses a multilayered metal oxide film of which first metal oxide layer is minutely rough such that the outer surface is scattered with numerous micro-pits and islet-like land regions, adherent to a glass substrate and superior in abrasion resistance, and of which second layer is superior in water repellence and adhesion to the first layer. The metal oxide film made from, for example, a metal alkoxide sol is high in transparency, hardness and durability. It is preferable to use, for example, Ti as a metal of the metal alkoxide. The second film contains a silane compound containing a fluorocarbon group to afford sufficient water repellence to the second layer. The maximum water repellence is limited to 110° to 115°, as expressed as contact angle of water drop on the second layer. It seems to be implicit from example 1 that the second layer is applied on the first layer with micropits, which therefore will be filled with the water repellent material.

In view of the above, the present invention in one preferred mode seeks to provide a waterdrop slidable surface structure which is excellent in water repellency and durability.

### SUMMARY OF THE INVENTION

It is one aspect of the present invention to provide a waterdrop slidable surface structure, which makes waterdrops dropped onto a substrate slide on a surface of the substrate. The waterdrop slidable surface structure comprises a waterdrop slidable layer arranged on the surface of the substrate and including a rigid layer and a water repellent layer. The rigid layer contains a rigid material having higher hardness than the substrate, and provides a continuous depression and protrusion surface. The water repellent layer mainly consists of a water repellent material of which contact angle for waterdrops dropped thereon is equal to or more than 90 degrees, and is filled in depression portions of the rigid layer.

According to this waterdrop slidable surface structure, when wipers (wiping means) wipe the waterdrop slidable layer as being the surface of the substrate (e.g. glass substrate), friction force applied from the wipers acts on the protrusion portions of the rigid layer at the distal regions. Since the distal region of each protrusion portion is highly hard and abrasion resistive, the repeated wiping-out action of the wipers does not cause abrasion of the protrusion portion. Further, because the water repellent layer which repels waterdrops dropped onto the substrate surface is filled in the depression portions of the continuous depression and protrusion surface of the rigid layer, the wipers do not exert friction fore on the water repellent layer, thereby preventing the water repellent layer from being worn. Moreover, since the water repellent layer is exposed to view for a large extent relative to the surface of the waterdrop slidable layer, surface of the waterdrop slidable layer provides high water repellent property and sustains better waterdrop slidable prroperty for waterdrops dropped onto the substrate.

Water repellency is evaluated based on a contact angle specified in JIS R3257 "Measuring method for wettability of glass substrate". The greater the contact angle, the better the water repellency, on the contrary, the smaller the contact angle, the better the wettability.

In the above waterdrop slidable surface structure, rigid protrusion portions that form part of the rigid layer may consist of a composite material, which contains the rigid material and a toughness material having higher toughness than the rigid material.

In general, rigid material is vulnerable and is likely to break or peel off from the substrate when it receives an impact. However, according to this waterdrop slidable surface structure, the rigid protrusion portions consist of a composite material, which contains the rigid material and a toughness material. Therefore, toughness is given to the rigid layer, and even if friction force is applied from the wiper, the rigid layer hardly breaks.

In the above waterdrop slidable surface structure, the rigid protrusion portions are formed such that the concentration of the toughness material becomes gradually higher from distal ends to proximal ends of the rigid protrusion portions.

According to this waterdrop slidable surface structure, the rigid protrusion portions are highly hard at the distal ends thereof while provide toughness at the proximal ends thereof. This can sustain abrasion resistance for wipers at the distal ends where the wipers contact directly, while relieving frictional stress received from the wipers at the proximal ends of the rigid protrusion portions. Energy of the wipers received at the rigid protrusion portions is consumed without wearing the distal ends of the rigid protrusion portions by deforming the proximal portions of the rigid protrusion portions which are mainly made of the toughness material, thereby preventing the rigid layer from being damaged.

In the above waterdrop slidable surface structure the waterdrop slidable layer may include a buffer layer consisting of a toughness material at a surface contacting the substrate.

According to this waterdrop slidable surface structure, the rigid layer and the substrate (e.g. glass substrate) are adhered through the buffer layer. This can improve adhesiveness between the rigid layer and the substrate, and because the friction force applied from the wipers is relieved by the buffer layer, it is possible to further prevent the rigid layer from being damaged.

In the above waterdrop slidable surface structure, the rigid material may contain DLC.

In the above waterdrop slidable surface structure, the water repellent material may contain fluororesin

Further, in the above waterdrop slidable surface structure, the toughness material may contain titanium oxide.

Further, the above waterdrop slidable surface structure may be used for a windshield of a vehicle.

According to these waterdrop slidable surface structures, the rigid layer is highly hard and less abrasive as the property of DLC (Diamond-Like Carbon). Also, the water repellent layer provides excellent water repellency as the property of fluororesin. Further, due to photocatalytic (band gap) reaction of titanium oxide that is used for the buffer layer, it is possible to obtain self-cleaning effect which can decompose and wash away dirt. If the glass substrate that is surface treated by this waterdrop slidable layer is adapted for a windshield of a vehicle where wipers repeatedly wipe out the surface, the glass substrate is hardly scratched and thus the waterdrop, slidable property and cleanness of the surface can be sustained over extended period of time.

Other features and advantages of the present invention will be apparent from the following description.

### BRIEF DESCRIPTION OF THE DRAWINGS

The aspects of the present invention will become more apparent by describing in detail illustrative, non-limiting embodiments thereof with reference to the accompanying drawings, in which:
FIG. 1A is,a sectional view schematically illustrating a basic arrangement of a waterdrop slidable surface structure according to the present invention;
FIG. 1B is a top plan view schematically illustrating the waterdrop slidable surface structure shown in FIG. 1A;
FIG. 2 is an enlarged sectional view of rigid protrusion portions ,of, the waterdrop slidable surface structure; and
FIG. 3 shows a basic arrangement of a sputtering apparatus for manufacturing the waterdrop slidable surface structure.

### DETAILED DESCRIPTION OF THE INVENTION

With reference to the accompanying drawings, preferred embodiments of the present invention will be described below.

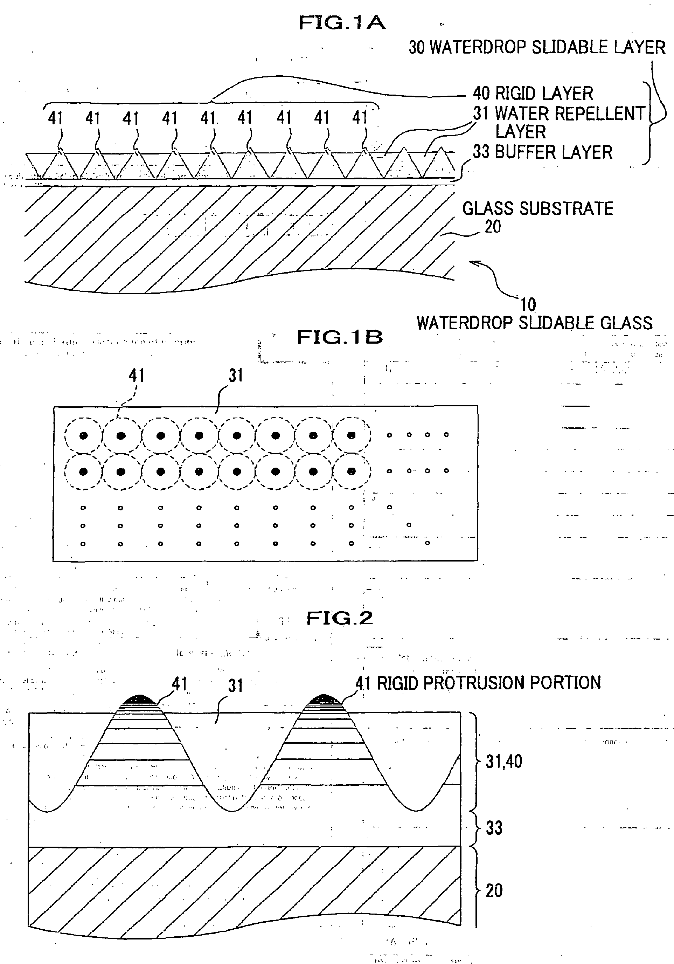

As shown in FIG. 1A, a waterdrop slidable glass 10 includes a glass substrate (substrate) 20 in the form of a plate and having visible light permeability, and a waterdrop slidable layer 30 provided at least one surface of the glass substrate 20. The waterdrop slidable layer 30 consists of a water repellent layer 31, a rigid layer 40, and a buffer layer 33.

The rigid layer 40 is formed as an assembly of rigid protrusion portions 41 that are uniformly arranged on the surface of the glass substrate 20 and substantially in the form of a cone with each distal end protruding upwardly. The surface of the rigid layer 40 includes a plurality of continuous depressions and protrusions. The rigid protrusion portions 41 mainly consist of a rigid material having higher hardness, of which hardness is measured based on "testing method for hardness of fine ceramics" defined in Japan Industrial Standard JIS R1610. In general, rigid material excels in abrasion resistance. Preferably, the rigid material used for the rigid layer 40 has hardness higher than the glass substrate 20, and for example, DLC (Diamond-Like Carbon) having excellent abrasion resistance is used. The surface of the glass substrate 20 is thus hardly scratched, and wear resulting from the wiping-out actions of the wiping means such as wipers (not shown) for wiping out waterdrops (not shown) sticking to the surface of the glass substrate 20 can be restricted.

As shown in FIG. 2, the rigid protrusion portions 41 consist of a composite material including the rigid material (DLC) as a primary component and a toughness material (titanium oxide) that is a primary component of a buffer layer 33 to be described later. The rigid protrusion portions 41 are formed such that the composition distribution (concentration) of the rigid material becomes gradually and continuously higher from the proximal ends to the distal ends of the rigid protrusion portions 41.

The distribution lines shown in FIG. 2 indicate the composition distribution of DLC, in which the concentration of DLC is higher as the line density is more densely distributed, and in which as the line density is more loosely distributed the concentration of DLC is lower and the concentration of titanium oxide is higher.

The buffer layer 33 positions between the rigid layer 40 and the glass substrate 20. The buffer layer 33 consists of a toughness material having higher toughness than the rigid layer 40 and the glass substrate 20. Herein, "higher toughness" indicates that a high energy is required to break the buffer layer 33 and thus the buffer layer 33 is not vulnerable. To be more specific, if the toughness material consists of titanium oxide, a synergy effect can be obtained such that titanium oxide shows excellent affinity for DLC and the glass substrate 20. The buffer layer 33 relieves or buffers an impact applied from the wipers to the rigid layer 40 so as to prevent the rigid layer 40 from being broken or peeled off from the glass substrate 20.

As best seen in FIG. 2, each of the rigid protrusion portions 41 is formed such that the coating film of the buffer layer 33 made of titanium oxide is partly raised to grow up in the vertical direction and becomes gradually narrower as going up to the grow-up direction and that the composition distribution of the rigid material (DLC) becomes continuously higher as going up in the grow-up direction. As described above, because the rigid protrusion portions 41 are formed such that the composition of the composite material consisting of the rigid material and the toughness material has a continuous gradient distribution from the,buffer layer 33, the rigid protrusion portions 41 and the buffer layer 33 are integrally formed without an interface therebetween. This can improve the adhesive strength of the rigid layer 40 relative to the glass substrate 20, thereby improving resistance to the friction force that is applied from the wipers.

Although the rigid layer 40 has been described above as it is adhered to the glass substrate 20 through the buffer layer 33, the rigid layer 40 may be adhered to the glass substrate 20 without interposing the buffer layer 33. In this instance, as described above, the rigid layer 40 may consist of a composite material with a gradient distribution including the rigid material and the toughness material and be directly adhered to the glass substrate 20. Alternatively, the rigid layer 40 may be of a homogeneous distribution of the rigid material and be directly adhered to the glass substrate 20.

The water repellent layer 31 consists of a water repellent material which excels in a property to repel waterdrops sticking to the surface. The water repellent material has a property such that the contact angle specified in Japan Industrial Standard JIS R3257 "Measuring method for wettability of glass substrate" is equal to or more than 90 degrees. For example, the water repellent material is composed of fluororesin including -CF₃ group as a functional group.

If fluororesin has more than 10 chains of -CF₃ group, in terms of the relation between hardness and water repellency, hardness of the fluororesin decreases while improving its water repellency or the hardness of the fluororesin increases while deteriorating its water repellency. Therefore, in order to obtain excellent waterdrop slidable property for waterdrops dropped onto the waterdrop slidable glass 10, it is preferable that fluororesin having higher water repellency (higher contact angle) such as of more than 10 chains of -CF₃ group is employed.

As shown in FIG. 1B, the water repellent layer 31 is arranged to fill in the depression portions (recessed portions between adjacent rigid protrusion portions 41) of the rigid layer 40, and the surface of the water repellent layer 31 provides a uniform and smooth surface over the glass substrate 20. The distal ends of the rigid protrusion portions 41 are exposed to view.

Explanation will be given to the waterdrop slidable glass according to the present invention when the wipers wipe out the surface thereof. When waterdrops (not shown) stick to the surface of the waterdrop slidable glass 10 shown in FIG. 1, the driver removes the waterdrops by the wiping-out operation of the wipers (not shown). In order to more effectively wipe out waterdrops, wiper blades of the wipers have to contact and slide on the surface of the waterdrop slidable glass 10 with a predetermined contact pressure.

Because of continuous wiping-out action of the wipers with the predetermined contact pressure, the surface of the waterdrop slidable layer 30 is repeatedly wiped. This repeated wiping-out action of the wipers applies impacts sufficient to wear the water repellent material (fluororesin) that forms the water repellent layer 31. However, most of the contact pressure of the wiper blades can be received by the distal ends of the rigid protrusion portions 41 that are uniformly distributed over the waterdrop slidable glass 10. Therefore, the surface of the water repellent layer 31 is hardly damaged. The distal ends of the rigid protrusion portions 41, to which the wipers contact and at which most of the contact pressure is received, are excellent in abrasion resistance and thus hardly worn by the repeated wiping-out action of the wipers.

Further, whenever the wipers wipe the surface of the waterdrop slidable layer 30, the buffer layer 33 to which the rigid protrusion portions 41 are fixed or the lower part of each rigid protrusion portion 41 deforms to relieve or buffer an impact received by the rigid protrusion portions 41. In general, the rigid material is vulnerable. However, only the distal ends of the rigid protrusion portions 41 are formed to have high hardness according to the waterdrop slidable glass 10, and it is possible to prevent the whole rigid protrusion portions 41 from peeling off from the glass substrate 20 due to fatigue and breakage of the rigid protrusion portions 41.

Waterdrop dropped onto the surface of the waterdrop slidable glass 10 forms a sphere, of which contact angle is equal to or more than 90 degrees, by the influence of the water repellent layer 31 that provides a hydrophobic property and occupies most of the surface of the waterdrop slidable glass 10. In the case where the waterdrop slidable glass 10 is arranged in a tilted manner, waterdrops can fall off the tilted surface by the gravity and without the aid of the wipers, thereby providing waterdrop slidable property.

The inventor has been discovered from a series of experiments that the higher the distal end of the rigid layer 41 exposed from the surface of the water repellent layer 31 provides hydrophilic property, the higher waterdrop slidable property does the waterdrop slidable glass 10 provide. Although details of the mechanism which causes the above phenomenon are not known, considerations can be suggested to the relation in that the waterdrop slidable glass 10 has the surface structure where hydrophobic portions and hydrophilic portions are alternately arranged to have a nano-structure and this may cause a higher water slidable effect.

The depression and protrusion surface of the waterdrop slidable glass 10 has a nano-order structure. Because protein that is the main component of dust or dirt has at most several microns to several tens of microns orders, it can not enter the depressions of the glass surface. It is therefore possible to prevent dust or dirt from sticking to the waterdrop slidable glass 10, which leads to a dirt-proof structure.

According to the waterdrop slidable glass 10, when the glass surface is wiped by the wipers (wiping means), the pressing force applied by the wipers is received by the distal ends of the protrusion portions of the rigid layer 40 and does not reach the water repellent layer 31, thereby preventing a wear of the water repellent layer 31. Even if a pressing force acts on the water repellent layer 31, a shearing force can be restricted and no peel-off occurs at the water repellent layer 31 because the water repellent layer 31 is filled in the depression portions. Further, because the waterdrop slidable glass 10 has a structure to ensure sufficient exposing area of the water repellent layer 31 relative to the glass surface to which waterdrops stick, it is possible to provide a waterdrop slidable glass having a surface structure which achieves high performance in both water repellency and durability.

### MANUFACTURING METHOD

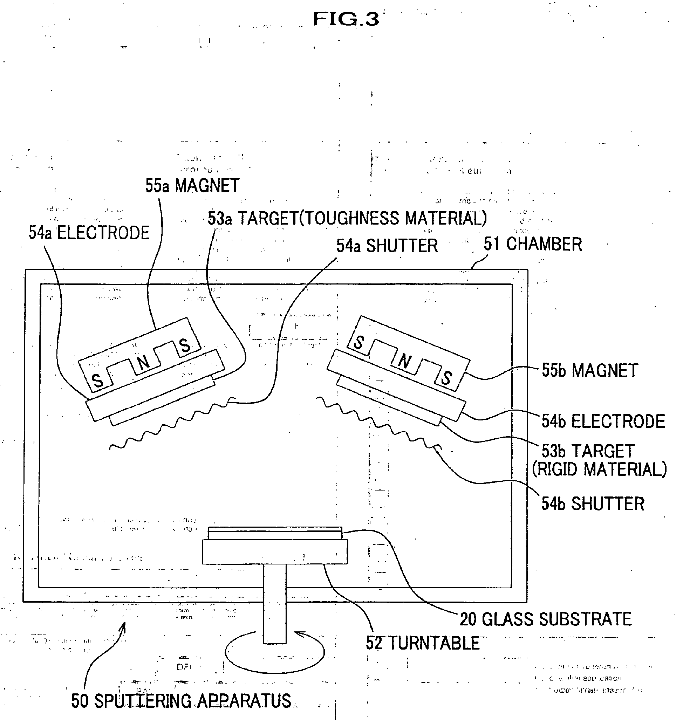

The surface structure of the waterdrop slidable glass 10 according to the present invention can be obtained by a thin-film deposition method using a known radio-frequency magnetron sputtering (RF-MS) method. With reference to FIG. 3 and also FIGS. 1A and 1B if necessary, the method of manufacturing a waterdrop slidable surface structure according to the present invention will be described.

As schematically shown in FIG. 3, a sputtering apparatus 50 using dual-target sputtering method includes a chamber 51 which can vacuumize the interior thereof, a turntable 52 for fixing and turning a glass substrate 20, a target 53a the surface of which is arranged a toughness material (titanium oxide) for forming the buffer layer 33 and forms a plasma by the electric field (made by an electrode 54a) and the magnetic field (made by a magnet 55a), and a target 53b the surface of which is arranged a rigid material (DLC) for forming the rigid layer 40 and forms a plasma by the electric field (made by an electrode 54b) and the magnetic field (made by a magnet 55b).

A shutter 54a, 54b is arranged at the opposite surface of each target 53a, 53b facing to the glass substrate 20. The shutter 54a, 54b adjusts the amount of sputtered particles irradiated from the target 53a, 53b and colliding with the glass substrate 20.

The manufacturing process of the waterdrop slidable glass 10 will be described below.

At first, a glass substrate 20 to which a glass cleaning has been applied is located on the turntable 52. Sputter source made of the toughness material (titanium oxide) and sputter source made of the rigid material (DLC) are attached to the corresponding target 53a, 53b, respectively.

After a vacuum is created within the chamber 51, argon (Ar) gas is introduced into the chamber 51. The gas pressure is controlled to such an extent necessary for obtaining stable discharge and stable sputtering, for example, in the range of 0.1 to 10 Pa. While controlling the gas pressure, temperature of the glass substrate 20 may be controlled by setting the surface temperature of the turntable 52 for a predetermined temperature (including unheating operation).

Next, high-frequency power is applied to the electrodes arranged at the targets 53a, 53b. A secondary electron irradiated from the surface of the target 53a, 53b obtains a centripetal force by the influence of the magnetic field, and travels on the target 53a, 53b drawing toroidal curve until it meets the argon (Ar) gas, to thereby produce plasma.

When the argon gas introduced into the chamber 51 collides with the electron, argon is ionized to sputter the target 53a, 53b. Titanium oxide is sputtered at the target 53a and DLC is sputtered at the target 53b, so that sputtered particles are deposited on the glass substrate 20 located on the turntable 52.

Sputtering for titanium oxide is executed while closing the shutter 54b, so that a film of titanium oxide is deposited on the glass substrate 20 to form the buffer layer 33. Sputtered particles of titanium oxide from the target 53a collide at high speed with the glass substrate 20 on the turntable 52. After the collision with the glass substrate 20, some of the particles of titanium oxide are reflected. The most of the remaining particles remain on the surface of the glass substrate 20, traveling on the surface of the glass substrate 20 and forming a particle group with other particles, so that a fixed core is formed partly on the glass substrate 20. Because of strong cohesion force of titanium oxide, sputtered particles of titanium oxide are deposited around the fixed core, and a depression and protrusion surface is formed.

When titanium oxide is deposited on the glass substrate 20 and forms the buffer layer 33 with a predetermined depth (preferably about 5nm), the shutter 54b for DLC is gradually open and the shutter 54a for titanium oxide is gradually closed. This operation makes it possible to gradually increase the concentration of DLC with regard to the sputtered particles colliding with the glass substrate 20.

In general, when a film is formed by the sputtering using amorphous material such as DLC (Diamond-Like Carbon), a smooth surface without depressions and protrusions can be obtained. On the other hand, when a film is formed by the sputtering using crystalline material such as titanium oxide, a surface with depressions and protrusions can be obtained. Therefore, if these materials are combined to form a film, it is possible to arbitrarily control the shape of the depression and protrusion surface.

Control of the depression and protrusion surface can be achieved, for example, by adjusting current density for the plasma discharge by varying strength of electric power or frequency inputted to the electrode of the target 53a, 53b so that speed of an atom (molecule) irradiated from the target can be adjusted, or by adjusting the shutter to adjust the rate of sputtered atoms.

By this process, the rigid layer 40 having a gradient distribution of the ratio between the rigid material (DLC) and the toughness material (titanium oxide) is formed on the glass substrate 20 through the buffer layer 33. When the rigid protrusion portions 41 of the rigid layer 40 grow to a predetermined height, the chamber 51 is open to the atmosphere and the glass substrate 20 is taken out from the chamber 51.

On the resulting glass substrate 20 is formed a waterdrop slidable layer 30 including the buffer layer 33 and the rigid layer 40 having continuous depressions and protrusions. Each rigid protrusion portion 41 which forms part of the rigid layer 40 has the height (depth) of 5 to 50 nm, preferable 10 to 30 nm, and the arrangement pitch of 10 to 200 nm, preferably 20 to 100 nm. The height of the rigid protrusion portion 41 substantially corresponds to the depth of the water repellent layer 31 arranged in the depressions between the rigid protrusion portions 41.

Next, film-forming process for depositing the water repellent layer 31 is carried out for the surface of the glass substrate 20 that has been taken out from the chamber 51. The film-forming process for the water repellent layer 31 is carried out by a coating method such as dipping method. To be more specific, the glass substrate 20 onto which the buffer layer 33 and the rigid layer 40 have been deposited is dipped in a sol containing fluoro-compound (ratio of propylene glycol methyl ether to distilled water is 50:50). The glass substrate 20 is then lifted at a predetermined speed, dried, and processed by a predetermined heat treatment to thereby stably fix the water repellent layer 31.

According to the above process, it is possible to provide a surface structure of the waterdrop slidable glass 10 which excels in waterdrop slidable property.

Although the above embodiment has been described for a film-forming method for continuously producing the buffer layer 33 and the rigid layer 40 on the glass substrate 20, each film may be produced individually. Further, the distal ends of the rigid protrusion portions 41 may be embedded in the water repellent layer 31 just after the deposit of the water repellent layer 31. This is because the rigid protrusion portions 41 will be worn and exposed to view as illustrated in FIG. 1A after repeated use of the wipers.

Also, a surface structure of the waterdrop slidable glass 10 according to the present invention is not limited to the specific embodiment in which the rigid layer 40 having a depression and protrusion surface is adhered to the glass substrate 20 through the buffer layer 33 with a predetermined depth. For example, the rigid layer 40 may be directly adhered to the glass substrate 20 without interposing the buffer layer 33. Further, in the above embodiment, the rigid protrusion portions 41 are formed to have a gradient distribution such that the concentration of the buffer material with higher toughness becomes gradually higher from the distal ends to the proximal ends that are adjacent to the glass substrate 20. However, the rigid protrusion portions 41 may be formed by a rigid material with homogeneous distribution.

Further, instead of producing the depressions and protrusions of the rigid layer 40 by the sputtering method, other physical or chemical methods may be used.

Waterdrop sticking to the surface of the waterdrop slidable glass 10 is not limited to water but may be oil or other material with a certain liquidity.

## Claims

1. A waterdrop slidable surface structure, which makes waterdrops dropped onto a substrate slide on a surface of the substrate, comprising:
a waterdrop slidable layer (30) arranged on the surface of the substrate (20) and including a rigid layer (40) and a water repellent layer (31),
wherein the rigid layer (40) contains a rigid material having higher hardness than the substrate and provides a continuous depression and protrusion surface,
wherein the rigid protrusion portions (41) form part of the rigid layer (40), and
wherein the water repellent layer (31) mainly consists of a water repellent material of which contact angle for waterdrops dropped thereon is equal to or more than 90 degrees, and is filled in depression portions of the rigid layer (40),
**characterized in that** the distal ends of the rigid protrusion portions (41) are exposed to view.

2. A waterdrop slidable surface structure according to claim 1, wherein rigid protrusion portions (41) that form part of the rigid layer (40) consist of a composite material, which contains the rigid material and a toughness material having higher toughness than the rigid material.

3. A waterdrop slidable surface structure according to any of the preceding claims, wherein the rigid protrusion portions (41) are formed such that the concentration of the toughness material becomes gradually higher from distal ends to proximal ends of the rigid protrusion portions (41).

4. A waterdrop slidable surface structure according to any one of claim 1 to claim 3, wherein the waterdrop slidable layer includes a buffer layer (33) consisting of a toughness material at a surface contacting the substrate.

5. A waterdrop slidable surface structure according to any one of claim 1 to claim 4, wherein the rigid material contains DLC.

6. A waterdrop slidable surface structure according to any one of claim 1 to claim 5, wherein the water repellent material contains fluororesin.

7. A waterdrop slidable surface structure according to any one of claim 2 to claim 6, wherein the toughness material contains titanium oxide.

8. A waterdrop slidable surface structure according to any one of claim 1 to claim 7, wherein the waterdrop slidable surface structure is used for a windshield of a vehicle.

9. A waterdrop slidable surface structure according to any one of claim 1 to claim 8, wherein the water-repellent layer (31) only partially fills the depression portions of the rigid layer (40).

## Patentansprüche

1. Oberflächenstruktur zum Abgleiten von Wassertropfen, durch die Wassertropfen, die auf ein Substrat getropft sind, auf einer Oberfläche des Substrats abgleiten, umfassend:
eine Schicht (30) zum Abgleiten von Wassertropfen, die auf einer Oberfläche eines Substrats (20) angebracht ist und eine starre Schicht (40) und eine wasserabstoßende Schicht (31) enthält,
wobei die starre Schicht (40) ein starres Material enthält, das eine höhere Härte als das Substrat aufweist und eine Oberfläche mit fortlaufenden Vertiefungen und Vorsprüngen enthält, wobei die starren vorspringenden Bereiche (41) einen Teil der starren Schicht (40) bilden, und
wobei die wasserabstoßende Schicht (31) hauptsächlich aus einem wasserabstoßenden Material besteht, dessen Kontaktwinkel für darauf getropfte Wassertropfen gleich oder höher 90 Grad ist, und das in den vertieften Bereichen der starren Schicht (40) gefüllt ist, **dadurch gekennzeichnet, dass** die distalen Enden der starren vorspringenden Bereiche (41) sichtbar sind.

2. Oberflächenstruktur zum Abgleiten von Wassertropfen gemäß Anspruch 1, wobei die starren vorspringenden Bereiche (41), die einen Bestandteil der starren Schicht (40) bilden, aus einem Verbundmaterial bestehen, das das starre Material und ein Festigkeitsmaterial enthält, das eine höhere Festigkeit als das starre Material aufweist.

3. Oberflächenstruktur zum Abgleiten von Wassertropfen gemäß einem der vorhergehenden Ansprüche, wobei die starren vorspringenden Bereiche (41) dergestalt ausgebildet sind, dass die Konzentration des Festigkeitsmaterials allmählich von den distalen Enden zu den proximalen Enden der starren vorspringenden Bereiche (41) ansteigt.

4. Oberflächenstruktur zum Abgleiten von Wassertropfen gemäß einem der Ansprüche 1 bis 3, wobei die Schicht zum Abgleiten der Wassertropfen eine Pufferschicht (33) umfasst, die aus einem Festigkeitsmaterial an einer Oberfläche besteht, die mit dem Substrat in Verbindung steht.

5. Oberflächenstruktur zum Abgleiten von Wassertropfen gemäß einem der Ansprüche 1 bis 4, wobei das starre Material DLC enthält.

6. Oberflächenstruktur zum Abgleiten von Wassertropfen gemäß einem der Ansprüche 1 bis 5, wobei das wasserabstoßende Material Fluorharz enthält.

7. Oberflächenstruktur zum Abgleiten von Wassertropfen gemäß einem der Ansprüche 2 bis 6, wobei das Festigkeitsmaterial Titanoxid enthält.

8. Oberflächenstruktur zum Abgleiten von Wassertropfen gemäß einem der Ansprüche 1 bis 7, wobei die Oberflächenstruktur zum Abgleiten von Wassertropfen für die Windschutzscheibe eines Fahrzeugs verwendet wird.

9. Oberflächenstruktur zum Abgleiten von Wassertropfen gemäß einem der Ansprüche 1 bis 8, wobei die wasserabstoßende Schicht (31) die vertieften Bereiche der starren Schicht (40) nur teilweise füllt.

## Revendications

1. Structure de surface permettant à l'eau de glisser, forçant ainsi des gouttes d'eau qui sont tombées sur un substrat à glisser sur une surface du substrat, comprenant :
une couche permettant à l'eau de glisser (30) agencée sur la surface du substrat (20) et comprenant une couche rigide (40) et une couche hydrophobe (31),
dans laquelle la couche rigide (40) comporte un matériau rigide possédant une dureté supérieure à celle du substrat et fournit une surface en creux et en saillie continue,
dans laquelle les parties en saillie rigides (41) font partie de la couche rigide (40), et
dans laquelle la couche hydrophobe (31) est essentiellement comporte un matériau hydrophobe dont l'angle de contact pour des gouttes d'eau qui sont tombées sur celui-ci est égal ou supérieur à 90 degrés, et est remplie de parties en creux de la couche rigide (40),
**caractérisée en ce que** les extrémités distales des parties en saillie rigides (41) sont visibles.

2. Structure de surface permettant à l'eau de glisser selon la revendication 1, dans laquelle des parties en saillie rigides (41) qui font partie de la couche rigide (40) comportent un matériau composite qui comporte le matériau rigide et un matériau tenace possédant une ténacité supérieure au matériau rigide.

3. Structure de surface permettant à l'eau de glisser selon l'une quelconque des revendications précédentes, dans laquelle les parties en saillie rigides (41) sont formées de sorte que la concentration du matériau tenace devienne progressivement plus importante des extrémités distales aux extrémités proximales des parties en saillie rigides (41).

4. Structure de surface permettant à l'eau de glisser selon l'une quelconque de la revendication 1 à la revendication 3, dans laquelle la couche permettant à l'eau de glisser comprend une couche tampon (33) comportant un matériau tenace au niveau d'une surface entrant en contact avec le substrat.

5. Structure de surface permettant à l'eau de glisser selon l'une quelconque de la revendication 1 à la revendication 4, dans laquelle le matériau rigide comporte du carbone sous forme de diamant amorphe (CDA).

6. Structure de surface permettant à l'eau de glisser selon l'une quelconque de la revendication 1 à la revendication 5, dans laquelle le matériau hydrophobe comporte de la fluororésine.

7. Structure de surface permettant à l'eau de glisser selon l'une quelconque de la revendication 2 à la revendication 6, dans laquelle le matériau tenace comporte de l'oxyde de titane.

8. Structure de surface permettant à l'eau de glisser selon l'une quelconque de la revendication 1 à la revendication 7, dans laquelle la structure de surface permettant à l'eau de glisser est utilisée pour un pare-brise d'un véhicule.

9. Structure de surface permettant à l'eau de glisser selon l'une quelconque de la revendication 1 à la revendication 8, dans laquelle la couche hydrophobe (31) remplit seulement partiellement les parties en creux de la couche rigide (40).
